# EUROPÄISCHE PATENTSCHRIFT

(11) **EP 2 146 870 B1**
(45) Veröffentlichungstag und Bekanntmachung des Hinweises auf die Patenterteilung: **15.05.2013**
(21) Anmeldenummer: 08717324.1
(22) Anmeldetag: 03.03.2008
(51) Int. Cl.: B60R 11/04, G02B 7/02, H01L 27/146, H01L 31/0203, H04N 5/225, B60R 11/00

(54) **KAMERAMODUL, INSBESONDERE FÜR EIN KRAFTFAHRZEUG**
CAMERA MODULE, PARTICULARLY FOR A MOTOR VEHICLE
MODULE DE CAMÉRA, EN PARTICULIER POUR UNE AUTOMOBILE

(30) Priorität: 12.04.2007 DE 102007017238
(43) Veröffentlichungstag der Anmeldung: 27.01.2010
(73) Patentinhaber: Robert Bosch GmbH, 70442 Stuttgart (DE)
(72) Erfinder: SEGER, Ulrich, 71229 Warmbronn (DE); GOTTWALD, Frank, 71287 Weissach (DE)
(86) Internationale Anmeldenummer: PCT/EP2008/052561
(87) Internationale Veröffentlichungsnummer: WO 2008/125386

(56) Entgegenhaltungen:
- EP-A- 0 308 749
- US-B1- 6 307 590
- US-B1- 6 507 700

## Beschreibung

Die Erfindung betrifft ein Kameramodul, das insbesondere für ein Fahrzeug einsetzbar ist, und ein Verfahren zu dessen Herstellung.

### Stand der Technik

Bei Kamerasystemen für Automotive-Anwendungen werden staubgeschützte und beschlagsfreie optische Module angestrebt. Staub und Feuchtigkeit vermindern die Qualität bzw. die Performance des optischen Systems im erheblichen Maße. Falls sich auf im optischen System Feuchtigkeit als Beschlag absetzt, wird in der Regel die Aufnahme eines brauchbaren Bildes unmöglich gemacht. Zur Vermeidung von Beschlag bzw. Kondenswasser durch eindringende Feuchtigkeit ist es bekannt, dass System bewusst offen zu gestalten oder es komplett hermetisch abzuschotten.

Der Bildaufnahme-Chip (Imager-Chip) und das ergänzend vorgesehene Abbildungssystem aus Linsen und/oder Spiegeln wird im Allgemeinen als Verbund auf den Schaltungsträger, z.B. eine Keramikplatte oder Leiterplatte, geklebt. Hierzu kann z.B. eine Objektivhalterung aus einem Metall auf der Keramik vorgesehen sein, in die das Objektiv eingeschraubt und gegebenenfalls verklebt wird.

Die Dichtigkeit der Klebung über dem gesamten erforderlichen Temperaturbereich von z.B. - 40 bis 120° C und die gesamte Lebensdauer der Kamera ist jedoch nicht unproblematisch. Die Klebungen müssen die Dichtheit und die Funktion des Imager-Moduls gleichermaßen bereitstellen.

Da herkömmliche Kameramodule im Allgemeinen nur eine begrenzte Dichtigkeit aufweisen, werden im Allgemeinen Linsen aus Mineralglas eingesetzt, die eine höhere Witterungsbeständigkeit aufweise, deren optische Eigenschaften jedoch begrenzt sind.

Die WO 2004/037622 A1 zeigt eine optische Einrichtung, bei der eine Kamera in ein Gehäuse eingesetzt ist, in das ein optisch transparentes Fenster mittels einer Dichtung eingesetzt ist. Hierbei sind Mittel zum Reinigen der Innenseite des Fensters vorgesehen, da grundsätzlich von einer Verschmutzung oder einem Beschlag des Fensters ausgegangen wird.

Die DE 199 55 229 C1 zeigt ein Endoskop mit einer digitalen Videokamera, die in einem Innenrohr angebracht und über Kabel kontaktiert ist, die in dem Innenrohr verlaufen und an dessen hinteren Ende durch eine Durchführung nach außen geführt sind, die zur Abdichtung als Glaseinschmelzung ausgebildet sein kann.

Die US 6,307,590 B1 zeigt eine gekühlte CCD-Kamera mit den Merkmalen des Oberbegriffs des Anspruchs 1, bei der ein CCD-Element in einem abgedichteten Gehäuse aus zwei Gehäuseteilen aufgenommen ist und eine elektrische Kontaktierung aus dem Gehäuse durch Glas abgedichtet ist. Die CCD-Kamera erfasst einen Außenraum durch eine optische Glasplatte. Vor der CCD-Kamera ist über einen Image-Intensifier 12 eine Kameralinse 13 angebracht.

Die US 6,507,700 B1 zeigt eine wasserdichte Kamera, bei der ein Gehäuse aus zwei Gehäuseteilen gebildet und abgedichtet ist. Vor dem Bildsensor ist ein Linsensystem angebracht, dessen vorderste Linse ein optisches Austrittsfenster aus dem Gehäuse darstellt und in einem Gehäuseteil abgedichtet ist.

Die EP 0 308 749 A2 beschreibt eine elektrooptische Baugruppe, in der Imager-Chip auf ein Schlatungsgeber befestigt und kontaktiert ist und optisch austritt durch ein optisches Fenster in Form einer lichtdurchlässigen Glasscheibe vorgesehen ist.

### Offenbarung der Erfindung

Der Erfindung liegt der Gedanke zugrunde, den Prozess der Abdichtung einerseits und den Prozess der Ausrichtung des Optikmoduls andererseits zu trennen.

Hierbei wird ein Optikmodul mit einem Schaltungsträger, z.B. einer Leiterplatte bzw. Keramikplatte, dem Bildaufnahme-Chip (Imagerchip) und dem Abbildungssystem, z.B. einem Linsensystem oder Spiegelsystem, in an sich bekannter Weise hergestellt. Auf dem Schaltungsträger werden der Imagerchip und weitere elektronische Komponenten wie z.B. das Steuer-ASIC angebracht und das Abbildungssystem auf einem entsprechenden Halter befestigt.

Erfindungsgemäß ist das Optikmodul undicht. Es ist offen ausgebildet, so dass keine unerwünschten Einschlüsse von Feuchtigkeit vorliegen können.

Die Dichtheit wird durch ein erfindungsgemäßes Gehäusekonzept erreicht. Der Schaltungsträger wird auf einem Gehäuseteil, z.B. dem Gehäuseboden angebracht. Dieses Gehäuseteil weist Durchführungen (Durchbrüche, Öffnungen) auf, in denen verglaste Durchführungen angeordnet sind. Somit sind Anschlusskontaktierungen vorgesehen, die vom Gehäuseinnenraum unter hermetischer Abdichtung durch die verglasten Durchführungen zum Außenraum geführt sind. Der Schaltungsträger wird auf dieses Gehäuseteil gesetzt und z.B. per Bond-Verbindungen mit den Anschlusskontaktierungen verbunden. Nachfolgend wird das Gehäuse geschlossen, vorteilhafterweise durch ein weiteres Gehäuseteil, insbesondere einen Gehäusedeckel. Grundsätzlich Ist allerdings auch ein Verschluss des Gehäusebodens durch den Schaltungsträger möglich, so dass bei einer derartigen Ausführungsform lediglich ein Gehäusteil erforderlich ist.

Bei der mehrteiligen Gehäuseausbildung sind die Gehäuseteile vorteilhafterweise aus Metall hergestellt und werden miteinander ohne ein organisches Verbindungsmittel unter hermetischer Abdichtung verbunden. Dies kann insbesondere eine Verschweißung sein, wobei als Schweißverfahren z.B. Rollnaht-Schweißen, Kalt-Schweißen, Laser-Schweißen, WiderstandsSchweißen oder z. B. Reibschweißen möglich ist. Es ergibt sich somit ein geschlossenes, hermetisch abgedichtetes Gehäuse, in dessen Gehäuseinnenraum das Optikmodul vorgesehen ist. Da somit sowohl die elektrischen Kontaktierungen als auch das das Optikmodul aufnehmende Gehäuse hermetisch abgedichtet sind, kann die optische Ausrichtung getrennt von der Abdichtung erfolgen.

Das Optikmodul mit dem Bildaufnahmechip sowie dem Abbildungssystem ist hierbei auf einen optischen Austritt gerichtet, der vorzugsweise als in das Gehäuse eingesetztes optisches Fenster aus z.B. Glas mit optischer Qualität ausgebildet sein kann. Dieses Glas ist mit dem Metall des Gehäuses in geeigneter Weise verbunden, z.B. verschmolzen oder mit einem O-Ring gedichtet. Vorteilhafterweise wird auch hier die Verwendung eines organischen Materials wie z.B. Kleber zur Abdichtung vermieden.

Das Optikmodul kann in dem Gehäuse insbesondere eingeschraubt werden; weiterhin sind hier grundsätzlich jegliche Verbindungen möglich, auch z.B. Einrasten oder Einstecken auf Anschlusskontaktierungen; grundsätzlich sind zwar auch Einklebungen möglich, vorteilhafterweise wird jedoch auch hier kein Kleber verwendet. Weiterhin kann die auf dem Schaltungsträger angebrachte Linsenaufnahme (lens holder) in einer konischen Form ausgeführt und in eine entsprechende Aufnahme am Gehäuseboden eingesetzt werden. Diese Verbindung kann dann verklebt oder mit einer Schraube gesichert werden.

Erfindungsgemäß ist somit eine grundsätzlich beliebige Ausbildung und Ausrichtung des Optikmoduls mit Bildaufnahmechip und Abbildungssystem möglich. Von dieser optischen Ausrichtung getrennt erfolgt eine hermetische Abdichtung durch das vorzugsweise metallische Gehäuse mit einer Kontaktierung, die aufgrund der Vergasung eine hermetische Dichtigkeit gewährleistet

Das erfindungsgemäße Hersteflungsvertahren kann hierbei grundsätzlich auf Standardtechniken wie das Ausbilden metallischer Gehäuseteile und Verbinden durch Verschweißen oder Löten zurückgreifen. Die Ausbildung der verglasten Durchführungen erfolgt in dem Gehäuse, so dass durch die Prozesstemperatur des Verglasens die empfindlichen Teile des Optikmoduls nicht beeinträchtigt werden.

Kurze Beschreibung der Zeichnungen
- Fig. 1a-f: zeigen teilweise geschnittene Seitenansichten erfindungsgemäßer Kamerasysteme gemäß unterschiedlichen Ausführungen;
- Fig. 2: zeigt ein Kameramodul entsprechend Fig. 1a, bei dem abweichend zu Fig. 1a jedoch das optische Fenster im Gehäuseboden vorgesehen ist, in a) Querschnitt und b) Draufsicht auf den Gehäuseboden;

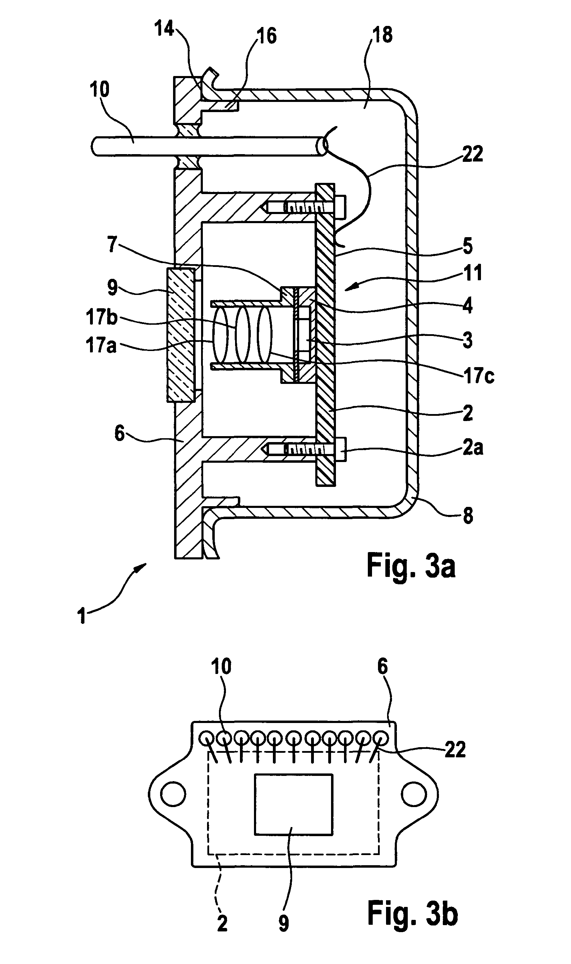

- Fig. 3: zeigt eine perspektivische Ansicht eines Kameramoduls gemäß Fig. 1d mit im Gehäuseboden ausgebildeten optischen Fenstern im a) Querschnitt und b) Aufsicht auf den Ghäuseboden;
- Fig. 4: einen Ausschnitt aus der Gehäusewand von Fig. 1 c, d, e bei aufgesetztem Gehäusedeckel;
- Fig. 5: ein Flussdiagramm eines erfindungsgemäßen Herstellungsverfahrens.

### Beschreibung der Ausführungsformen

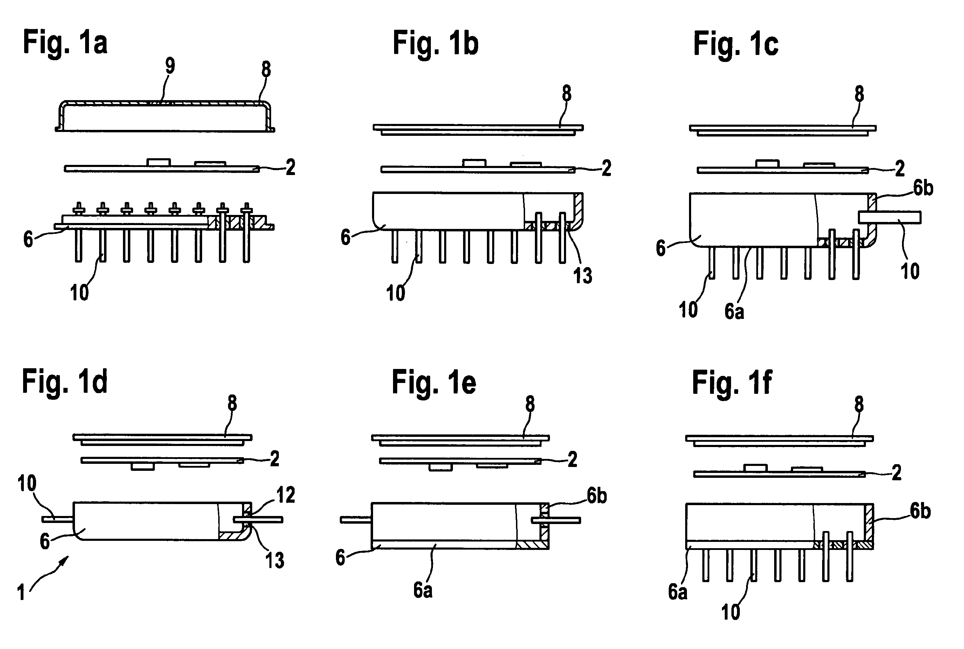

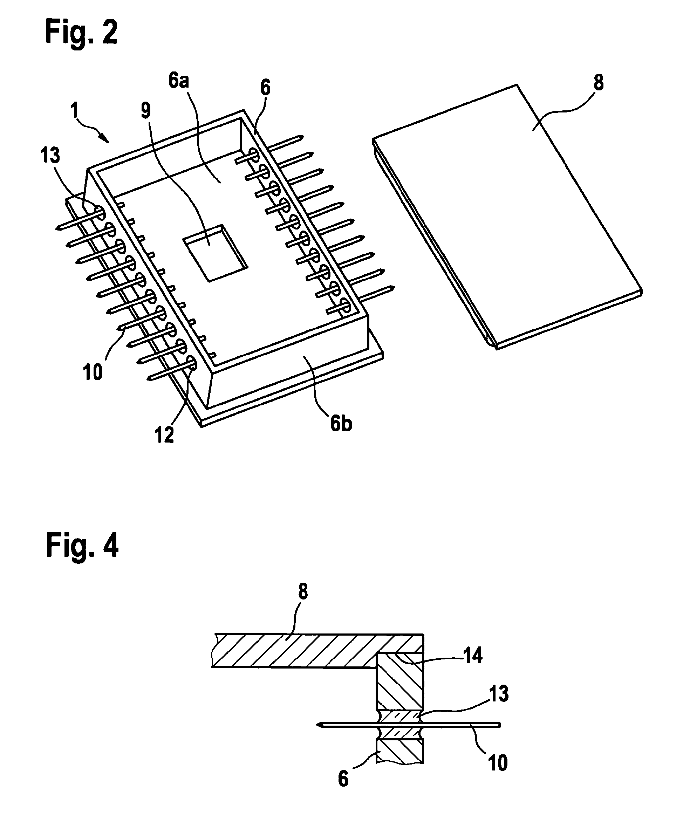

Ein erfindungsgemäßes Kameramodul 1 weist gemäß Fig. 1a und Fig. 2 ein aus einem Gehäuseboden 6 und einem Gehäusedeckel 8 gebildetes Gehäuse aus Metall und ein in das Gehäuse 6, 8 gesetztes Optikmodul 11 auf. Das Optikmvdul 11 weist eine als Schaltungsträger dienende Leiterplatte 2 mit einem in einem Chipgehäuse 4 aufgenommenen Imager-Chip 3 (Bildaufnahme-Chip) und weiteren elektronischen Komponenten, z.B. einem Steuer-ASIC, sowie ein Abbildungssystem 7 auf. Die Leiterplatte 2 ist über z. B. Schrauben 2a am Gehäuseboden 6 befestigt. Das Abbildungssystem 7 ist z. B. als Linsensystem mit ein oder mehreren Linsen 17 a, b, c oder auch als Spiegelsystem ausgebildet. Hierbei ist eine die Linsen 17 a, b, c aufnehmende Linsenfassung 19 (oder entsprechend eine Spiegelfassung) bereits als Teil des Optikmoduls 11 ausgebildet und z. B. auf der Leiterplatte 2 oder auf dem Chipträger 4 montiert. Die Linsenfassung 19 kann hierbei in nicht gezeigter Weise auf dem Gehäuseboden abgestützt sein, z. B. in einer konischen Aufnahme des Gehäusebodens.

Der Imager-Chips 3 ist auf ein optisches Fenster 9 gerichtet, das bei der Ausführungsform der Fig. 4 im Gehäuseboden 6 vorgesehen ist. Wie in Fig. 1d gezeigt kann das optische Fenster 9 grundsätzlich auch im Gehäusedeckel 8 angebracht sein. Das optische Fenster 9 aus z. B. Glas in optischer Qualität kann mit dem Gehäuseboden 6 Gehäuse verschmolzen, verklebt oder mittels eines O-Rings verbunden sein.

In dem Gehäuseboden 6 sind mehrere Durchführungen 12 ausgebildet, durch die sich jeweils Anschlusspins 10 zur Kontaktierung der Leiterplatte 2, d.h. insbesondere auch des Imager-Chips 3, erstrecken. Die Anschlusspins 10 sind z. B. über Drahtbonds 22 mit Kontaktpads 5 an der Rückseite der Leiterplatte 2 kontaktiert. Erfindungsgemäß sind die Durchführungen 12 zur hermetischen Abdichtung des Gehäuseinnenraums 18 gegenüber dem Außenraum 20 sowie zur elektrischen Isolierung der Anschlusspins 10 verglast, d.h. es sind Glasdichtungen 13 aus einem Float-Glas, das z. B. bei 300° C schmilzt, eingebracht. Das Optikmodul 11 ist bewusst undicht gehalten, d.h., dass innerhalb des Gehäuseinnenraums 18 Luft in die Linsenfassung 19 und zwischen die Linsen 17 a, b, c treten kann.

Der Gehäusedeckel 8 ist auf dem Gehäuseboden 6 mittels einer Schweißverbindung 14 befestigt, die durch ein übliches Schweißverfahren, z.B. Rollnat-Schweißen, Kalt-schweißen, Laser-Schweißen oder WiderstandsSchweißen ausgebildet werden kann. Vorteilhafterweise weist der Gehäuseboden 6 oder der Gehäusedeckel 8 hierzu eine Stufe 16 auf, um die Dichtfläche für die Schweißnaht 14 zu erhöhen.

Die Schweißnaht 14 ist umlaufend, so dass der von dem geschlossenen Gehäuse 6, 8 umgebende Gehäuseinnenraum 18 gegenüber dem Außenraum 20 hermetisch abgedichtet ist. Somit unterliegt auch die Leiterplatte 2 mit ihren Komponenten 3, 4 nicht mehr den äußeren Witterungseinflüssen da sowohl die Glasdichtung 13 der Verglasung als auch die Schweißverbindung 14 eine hermetische Abdichtungen ohne Gastransport und Feuchtigkeitstransport sicherstellen.

Anstelle der Schweißnaht 14 kann auch eine entsprechende Lötverbindung ausgebildet werden. Erfindungsgemäß sind anstelle der Schweißverbindung 14 sowie der Glasdichtung 13 vorteilhafterweise jedoch keine stoffflüssigen Verbindungen mit organischem Material, z.B. Klebstoffverbindungen oder andere organische Dichtungen, vorgesehen, da diese erfindungsgemäß als nicht hinreichend dicht erkannt werden.

Bei der Ausführungsform der Fig. 1a, 2 ist der Gehäusedeckel 8 topfförmig ausgebildet. Gemäß der Ausführungsformen der Fig. 1 b,c,d,e und Fig. 2 ist stattdessen der Gehäuseboden 6 topfförmig ausgebildet, so dass der Gehäusedeckel 8 im wesentlichen flach ausgebildet ist. Hierbei weist bei Fig. 2 der Gehäuseboden 6 eine Bodenfläche 6a, in der das optische Fenster 9 ausgebildet ist, und eine sich nach oben erstreckende Seitenwand 6b, auf die von oben der Gehäusedeckel 8 gesetzt ist. Gemäß Fig. 1 d, e, f sind die Durchführungen 12 für die Anschlusspins 10 in der Seitenwand b ausgebildet und wiederum verglast, so dass die Anschlusspins 10 horizontal seitlich nach außen verlaufen. Gemäß Fig. 1 b, f sind die Durchführungen 12 in der Bodenfläche 6b ausgebildet, so dass die Anschlusspins 10 - entsprechend Fig. 1a - nach unten verlaufen. Bei der Ausführungsform der Fig. 1 c liegen beide Verläufe vor. Das optische Fenster 9 kann bei allen Ausführungsform wahlweise im Gehäuseboden 6 oder im Gehäusedeckel 8 vorgesehen sein. Fig. 4 zeigt den Ausschnitt IV aus Fig. 1d, allerdings in geschlossenem Zustand des Gehäuses 6, 8, mit den Glasdichtungen 13 in den Durchführungen 12 und der Schweißnaht 14.

Durch die Verwendung von Gehäuseteilen 6, 8 aus Metall wird eine hohe EMV-Verträglichkeit bzw. Abschirmung gegenüber schädlichen elektromagnetischen Strahlungen gewährleistet. Der Gehäuseboden 6 kann jeweils kostengünstig z.B. als Tiefziehteil mit entsprechenden Bohrungen für die Durchführungen 12 ausgebildet sein. Auch der Gehäusedeckel 8 kann entsprechend als Tiefziehteil oder Stanzteil ausgebildet sein.

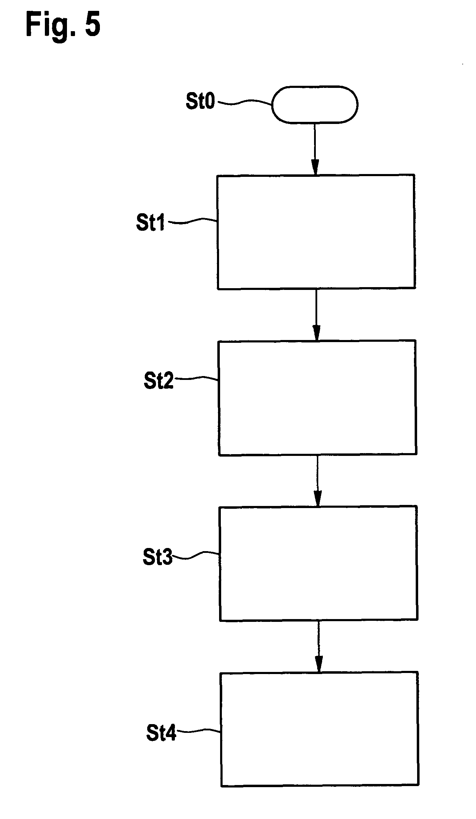

Das erfindungsgemäße Herstellungsverfahren beginnt somit gemäß Fig. 5 in Schritt St0 beim Start des Verfahrens. In Schritt St1 werden der Gehäuseboden 6 und Gehäusedeckel 8 separat aus Metall ausgebildet, je nach Formgebung durch z.B. ein Tiefziehverfahren, und die Durchführungen 12 z.B. als Bohrungen ausgebildet. Nachfolgend werden in Schritt St2 die Anschlusspins 10 eingesetzt und die Durchführungen 12 verglast, d.h. Glasdichtungen 13 bei z.B. 300° C eingeschmolzen, wodurch die Anschlusspins 10 von der metallischen Seitenwand 6b isoliert werden.

In den Gehäuseboden 6 wird nachfolgend in Schritt St3 das Optikmodul 11 eingesetzt und gegebenenfalls ausgerichtet. Die Leiterplatte 2 wird eingeschraubt und mit dem Anschlusspins 10 über die Drahtbonds 22 kontaktiert. Hierbei ist die Ausrichtung durch beliebige Hilfsmittel möglich, da erfindungsgemäß die Ausrichtung von der Abdichtung getrennt ist. Somit kann z. B. auch eine Justage erfolgen, indem der Imager-Chip 3 durch das optische Fenster 9 ein Objekt erfasst, Sensorsignale des Imagerchips 3 ausgelesen werden und z. B. das Abbildungssystem 7 verstellt wird.

In Schritt St4 wird nachfolgend der Gehäusedeckel 8 auf die Seitenwand 6a des Gehäusebodens 6 gesetzt und durch Ausbildung der Schweißnaht 14 hermetisch abdichtend verschweißt, so dass nachfolgend der Gehäuseinnenraum 18 gegenüber dem Außenraum 20 hermetisch abgedichtet ist.

## Patentansprüche

1. Kameramodul, insbesondere für ein Fahrzeug, wobei das Kameramodul mindestens aufweist:
ein Gehäuse (6, 8) mit einem Gehäuseinnenraum (18), und
ein Optikmodul (11), das in dem Gehäuseinnenraum (18) angeordnet ist und
einen Schaltungsträger (2) mit einem Bildaufnahme-Chip (3) und elektrische Kontaktierungen (10) aufweist,
wobei das Optikmodul) (11) durch einen optischen Austritt (9) auf einen Außenraum (20) außerhalb des Gehäuses (6, 8) gerichtet ist,
wobei die elektrischen Kontaktierungen (10) von dem Optikmodul (11) durch Durchführungen (12) im Gehäuse nach außen geführt sind zur Kontaktierung des Kameramoduls,
wobei der Gehäuseinnenraum (18) gegenüber dem Außenraum (20) hermetisch abgedichtet ist,
wobei das Gehäuse mindestens zwei Gehäuseteile (6, 8) aufweist, die in einer hermetisch dichten Verbindung (14) miteinander verbunden sind, und
der optische Austritt (9) durch ein optisches Fenster (9) aus transparentem Material gebildet ist, das in einem Gehäuseteil (6, 8) abgedichtet vorgesehen ist
**dadurch gekennzeichnet, dass**
das Optikmodul (11) ein vor dem Bildaufnahme-Chip (3) angeordnetes, auf dem Schaltungsträger (2) befestigtes, vollständig in dem Gehäuseinnenraum (18) angeordnetes Abbildungssystem (7) aufweist, und
das Optikmodul (11) undicht ausgebildet ist, wobei es derart Offen ausgebildet ist,
dass keine unerwünschten Einschlüsse von Feuchtigkeit vorliegen können.

2. Kameramodul nach Anspruch 1, **dadurch gekennzeichnet, dass** die mindestens zwei Gehäuseteile (6, 8) aus Metall hergestellt sind und in einer Schweißnaht (14) und/oder Lötverbindung hermetisch dicht verbunden ist.

3. Kameramodul nach Anspruch 2, **dadurch gekennzeichnet, dass** als Gehäuseteile ein Gehäuseboden (6), an dem der Schaltungsträger (2) befestigt ist, und ein auf den Gehäuseboden gesetzter Gehäusedeckel (8) vorgesehen sind, die in der umlaufenden Schweißnaht (14) oder Lötverbindung hermetisch dicht verbunden sind.

4. Kameramodul nach Anspruch 3, **dadurch gekennzeichnet, dass** der Gehäuseboden (6) topförmig mit einer Bodenfläche (6a) und einer umlaufenden Seitenwand (6b) ausgebildet ist,
wobei der Gehäusedeckel (8) auf die Seitenwand (6b) gesetzt ist.

5. Kameramodul nach Anspruch 3, **dadurch gekennzeichnet, dass** der Gehäusedeckel (8) topfförmig mit einem flachen Teil und einer Seitenwand (8a) ausgebildet und auf den Gehäuseboden gesetzt ist.

6. Kameramodul nach einem der Ansprüche 3 bis 5, **dadurch gekennzeichnet, dass** die Anschlusskontaktierungen (10) vom Gehäuseinnenraum (18) nach unten durch den Gehäuseboden (6) und/oder seitlich durch die Seitenwand (6b) nach außen verlaufen.

7. Kameramodul einem der vorherigen Ansprüche, **dadurch gekennzeichnet, dass** die Durchführungen (12) durch Glasdichtungen (13) unter elektrischer Isolierung der Kontaktierungen abgedichtet sind.

8. Kameramodul Anspruch 7, **dadurch gekennzeichnet, dass** als Kontaktierungen Anschlusspins (10) vorgesehen sind, die im Gehäuseinnenraum (18) mit dem Schaltungsträger (2) kontaktiert sind und in den verglasten Durchführungen (12) durch das Gehäuse nach außen verlaufen zur Kontaktierung des Kameramoduls.

9. Kameramodul nach Anspruch 7 oder 8, **dadurch gekennzeichnet, dass** die in die Durchführungen (12) eingesetzten Glasdichtungen (13) aus einem Glasmaterial gefertigt sind, das in einem Temperaturbereich zwischen 250° C und 350° C, z. B. bei etwa 300° C aufschmelzbar ist, insbesondere ein Float-Glasmaterial.

10. Kameramodul nach einem der vorherigen Ansprüche, **dadurch gekennzeichnet, dass** das optische Fenster (9) mit dem Gehäuse verschmolzen oder mittels eines O-Rings verbunden ist.

11. Kameramodul nach einem der vorherigen Ansprüche, **dadurch gekennzeichnet, dass** sämtliche Abdichtungen des Gehäuses (6, 8) frei von organischem Material sind.

12. Kameramodul nach einem der vorherigen Ansprüche, **dadurch gekennzeichnet, dass** das Abbildungssystem (7) ein Linsensystem und/oder Spiegelsystem aufweist.

13. Kameramodul Anspruch 12, **dadurch gekennzeichnet, dass** Abbildungssystem (7) ein Linsensystem mit Linsenfassung (19) und Linsen (17a, 17b, 17c) aufweist und innerhalb des Gehäuseinnenraums (18) ein Lufteintritt in die Linsenfassung (19) und zwischen die Linsen (17a, 17b, 17c) vorgesehen ist.

14. Kameramodul nach einem der vorherigen Ansprüche, **dadurch gekennzeichnet, dass** der das Optikmodul (11) aufnehmende Gehäuseinnenraum (18) gegenüber einem Außenraum (20) mit einer Dichtigkeit von kleiner/gleich 10⁻⁷ m²/s, z.B. kleiner/gleich 10⁻⁸ m²/s im Helium-Lecktest ausgebildet ist.

15. Verfahren zum Herstellen eines Kameramoduls, mit mindestens folgenden Schritten:
Herstellen eines undichten Optikmoduls (11), das derart Offen ausgebildet ist, dass keine unerwünschten Einschlüsse von Feuchtigkeit vorliegen können, mit einem einen Bildaufnahme-Chip (3) und ein Abbildungssystem (7) aufnehmenden Schaltungsträger (2),
Herstellen eines Gehäuses aus mindestens zwei Gehäuseteilen (6, 8) aus Metall mit Durchführungen (12),
Einsetzen des Optikmoduls (11) in ein Gehäuseteil,
wobei ein optischer Austritt (9) durch ein optisches Fenster (9) aus transparentem Material gebildet wird, das in einem Gehäuseteil (6, 8) abgedichtet vorgesehen ist,
Einsetzen von Anschlusskontaktierung (10) durch die Durchführungen (12),
Verglasen der Durchführungen derartig, dass die Anschlusskontaktierungen elektrisch vom Gehäuse isoliert und die Durchführungen hermetisch abgedichtet sind,
Kontaktieren des Optikmoduls (11) mit den Anschlusskontaktierungen, und
Verschließen und hermetisches Abdichten des Gehäuses.

## Claims

1. Camera module, particularly for a vehicle, the camera module having at least:
a housing (6, 8) with an interior housing space (18), and
an optics module (11), which is arranged in the interior housing space (18) and has a leadframe (2) with an image pickup chip (3) and electrical contacts (10),
the optics module (11) being directed through an optical exit (9) onto an exterior space (20) outside the housing (6, 8),
the electrical contacts (10) being led from the optics module (11) through bushings (12) in the housing to the outside for contacting the camera module,
the interior housing space (18) being hermetically sealed with respect to the exterior space (20),
the housing having at least two housing parts (6, 8), which are connected to one another in a hermetically sealed connection (14), and the optical exit (9) being formed by an optical window (9) of transparent material, which is provided in a sealed way in a housing part (6, 8),
**characterized in that**
the optics module (11) has an imaging system (7), which is arranged ahead of the image pickup chip (3), is fastened on the leadframe (2) and is arranged completely in the interior housing space (18), and
the optics module (11) is formed in an unsealed way, it being formed in an open way such that no undesired inclusions of moisture can occur.

2. Camera module according to Claim 1, **characterized in that** the at least two housing parts (6, 8) are produced from metal and are connected in a hermetically sealed form in a weld seam (14) and/or soldered connection.

3. Camera module according to Claim 2, **characterized in that** a housing base (6), to which the leadframe (2) is fastened, and a housing cover (8), which is placed on the housing base, are provided as housing parts, which are connected in a hermetically sealed form in the peripheral weld seam (14) or soldered connection.

4. Camera module according to Claim 3, **characterized in that** the housing base (6) is formed in the way of a pot, with a bottom surface (6a) and a peripheral side wall (6b), the housing cover (8) being placed on the side wall (6b).

5. Camera module according to Claim 3, **characterized in that** the housing cover (8) is formed in the way of a pot, with a flat part and a side wall (8a), and is placed on the housing base.

6. Camera module according to one of Claims 3 to 5, **characterized in that** the connection contacts (10) run from the interior housing space (18) downwards through the housing base (6) and/or laterally through the side wall (6b) to the outside.

7. Camera module according to one of the preceding claims, **characterized in that** the bushings (12) are sealed by glass seals (13) with electrical insulation of the contacts.

8. Camera module according to Claim 7, **characterized in that** connection pins (10) that are in electrical contact with the leadframe (2) in the interior housing space (18) and run in the glazed bushings (12) through the housing to the outside for contacting the camera module are provided as contacts.

9. Camera module according to Claim 7 or 8, **characterized in that** glass seals (13) inserted into the bushings (12) are produced from a glass material that can be melted in a temperature range between 250°C and 350°C, for example at approximately 300°C, in particular a float glass material.

10. Camera module according to one of the preceding claims, **characterized in that** the optical window (9) is fused with the housing or connected by means of an O-ring.

11. Camera module according to one of the preceding claims, **characterized in that** all of the seals of the housing (6, 8) are free from organic material.

12. Camera module according to one of the preceding claims, **characterized in that** the imaging system (7) has a lens system and/or mirror system.

13. Camera module according to Claim 12, **characterized in that** the imaging system (7) has a lens system with a lens mount (19) and lenses (17a, 17b, 17c) and an air inlet into the lens mount (19) and between the lenses (17a, 17b, 17c) is provided within the interior housing space (18).

14. Camera module according to one of the preceding claims, **characterized in that** the interior housing space (18) receiving the optics module (11) is formed with a sealing integrity with respect to an exterior space (20) of less than/equal to 10⁻⁷ m²/s, for example less than/equal to 10⁻⁸ m²/s, in the helium leak test.

15. Method for producing a camera module, comprising at least the following steps:
producing an unsealed optics module (11), which is formed in an open way such that no undesired inclusions of moisture can occur, with a leadframe (2) receiving an image pickup chip (3) and an imaging system (7),
producing a housing from at least two housing parts (6, 8) of metal with bushings (12),
inserting the optics module (11) into a housing part,
an optical exit (9) being formed by an optical window (9) of transparent material, which is provided in a sealed way in a housing part (6, 8),
inserting connection contacts (10) through the bushings (12),
glazing the bushings in such a way that the connection contacts are electrically insulated from the housing and the bushings are hermetically sealed,
contacting the optics module (11) with the connection contacts, and closing and hermetically sealing the housing.

## Revendications

1. Module de caméra, notamment pour un véhicule, le module de caméra comprenant au moins :
un carter (6, 8) pourvu d'un espace intérieur de carter (18) ; et
un module optique (11) disposé dans l'espace intérieur de carter (18) et comportant un support de circuit (2) avec une puce d'enregistrement d'image (3) et des contacts électriques (10) ;
le module optique (11) étant aligné, à travers une sortie optique (9), sur un espace extérieur (20) situé à l'extérieur du carter (6, 8) ;
les contacts électriques (10) du module optique (11) étant guidés vers l'extérieur à travers les passages (12) prévus dans le carter pour réaliser la mise en contact du module de caméra ;
l'espace intérieur de carter (18) étant étanchéifié de façon hermétique par rapport à l'espace extérieur (20) ;
le carter comportant au moins deux parties de carter (6, 8) reliées entre elles en une liaison (14) hermétique étanche et la sortie optique (9) étant formée en matière transparente par une fenêtre optique (9) prévue de façon étanchéifiée dans une partie de carter (6, 8) ;
**caractérisé en ce que** :
le module optique (11) comporte un système de reproduction (7) disposé avant la puce d'enregistrement d'image (3), fixé au support de circuit (2) et entièrement disposé dans l'espace intérieur de carter (18) ; et
le module optique (11) est réalisé de façon non étanche, celui-ci étant réalisé de façon ouverte de telle sorte qu'aucune inclusion non souhaitée d'humidité ne puisse se produire.

2. Module de caméra selon la revendication 1, **caractérisé en ce que** les au moins deux parties de carter (6, 8) sont fabriquées en métal et sont reliées hermétiquement de façon étanche en une soudure (14) et/ou liaison brasée.

3. Module de caméra selon la revendication 2, **caractérisé en ce que** les parties de carter prennent la forme d'un fond de carter (6) auquel le support de circuit (2) est fixé et d'un couvercle de carter (8) placé sur le fond de carter relié hermétiquement de façon étanche en une soudure (14) ou une liaison brasée périphérique.

4. Module de caméra selon la revendication 3, **caractérisé en ce que** le fond de carter (6) prend une forme de pot avec une surface de fond (6a) et une paroi latérale (6b) périphérique, le couvercle de carter (8) étant placé sur la paroi latérale (6b).

5. Module de caméra selon la revendication 3, **caractérisé en ce que** le couvercle de carter (8) prend une forme de pot avec une partie plate et une paroi latérale (8a) et est placé sur le fond de carter.

6. Module de caméra selon l'une quelconque des revendications 3 à 5, **caractérisé en ce que** les contacts de raccord (10) s'étendent depuis l'espace intérieur de carter (18) vers le bas à travers le fond de carter (6) et/ou en côté à travers la paroi latérale (6b), vers l'extérieur.

7. Module de caméra selon l'une quelconque des revendications précédentes, **caractérisé en ce que** les passages (12) sont étanchéifiés par des joints de verre (13) par isolation électrique des contacts.

8. Module de caméra selon la revendication 7, **caractérisé en ce que** les contacts utilisés sont des broches de raccordement (10) mises en contact avec le support de circuit (2) dans l'espace intérieur de carter (18) et s'étendant vers l'extérieur dans les passages (12) au travers du carter vitrifié pour mettre en contact le module de caméra.

9. Module de caméra selon la revendication 7 ou 8, **caractérisé en ce que** les joints de verre (13) utilisés dans les passages (12) sont fabriqués à partir d'un verre pouvant être fondu dans une plage de température comprise entre 250 °C et 350 °C, par exemple d'approximativement 300 °C, notamment un verre flotté.

10. Module de caméra selon l'une quelconque des revendications précédentes, **caractérisé en ce que** la fenêtre optique (9) est fondue avec le carter ou reliée à l'aide d'un joint torique.

11. Module de caméra selon l'une quelconque des revendications précédentes, **caractérisé en ce que** l'ensemble des joints du carter (6, 8) sont exempts de matière organique.

12. Module de caméra selon l'une quelconque des revendications précédentes, **caractérisé en ce que** le système de reproduction (7) comporte un système de lentilles et/ou un système de miroir.

13. Module de caméra selon la revendication 12, **caractérisé en ce que** le système de reproduction (7) comporte un système de lentilles doté d'un cadre de lentilles (19) et de lentilles (17a, 17b, 17c) et **en ce qu'**une entrée d'air est prévue dans le cadre de lentilles (19) et entre les lentilles (17a, 17b, 17c), à l'intérieur de l'espace intérieur de carter (18).

14. Module de caméra selon l'une quelconque des revendications précédentes, **caractérisé en ce que** l'espace intérieur de carter (18) abritant le module optique (11) est réalisé avec une étanchéité inférieure ou égale à 10⁻⁷ m²/s, par exemple inférieure ou égale à 10⁻⁸ m²/s par rapport à l'espace extérieur (20), au test de fuite à l'hélium.

15. Procédé de fabrication d'un module de caméra, avec au moins les étapes suivantes :
fabrication d'un module optique (11) non étanche réalisé de façon ouverte de telle sorte qu'aucune inclusion d'humidité non souhaitée ne puisse se produire, avec un support de circuit (2) recevant une puce d'enregistrement d'image (3) et un système de reproduction (7) ;
fabrication d'un carter à partir d'au moins deux parties de carter (6, 8) réalisées en métal avec des passages (12) ;
mise en place du module optique (11) dans une partie de carter ;
une sortie optique (9) étant formée en matière transparente au travers d'une fenêtre optique (9),
ladite sortie étant prévue de façon étanchéifiée dans une partie de carter (6, 8) ;
insertion des contacts de raccord (10) au travers des passages (12) ;
vitrification des passages de telle sorte que les contacts sont isolés sur le plan électrique du carter et que les passages sont hermétiquement étanchéifiés ;
mise en contact du module optique (11) avec les contacts de raccord et fermeture et étanchéification hermétique du carter.
